# EUROPEAN PATENT APPLICATION

(11) **EP 4 322 227 A1**
(43) Date of publication of application: **14.02.2024**
(21) Application number: 22765738.4
(22) Date of filing: 30.06.2022
(51) Int. Cl.: H01L 31/0216, H01L 31/02, H01L 31/068, H01L 31/18

(54) **SOLAR CELL STRUCTURE AND MANUFACTURING METHOD THEREFOR**

(71) Applicant: Hengdian Group DMEGC Magnetics Co., Ltd., Dongyang, Zhejiang 322118 (CN)
(72) Inventor: The designation of the inventor has not yet been filed
(74) Representative: DehnsGermany Partnerschaft von Patentanwälten
(86) International application number: PCT/CN2022/102807
(87) International publication number: WO 2024/000399

(57) **Abstract**

The present disclosure provides a solar cell structure and a manufacturing method thereof. The solar cell structure includes a semiconductor substrate having a first doped region and a second doped region formed on a back side of the semiconductor substrate; a first heavily doped region formed in the semiconductor substrate, the first heavily doped region being disposed in contact with a side of the first doped region away from the back side, either of the first heavily doped region and the first doped region being a P-type doped region, and a doping concentration of the first heavily doped region being greater than a doping concentration of the first doped region; a second heavy doped region formed in the semiconductor substrate, the second heavy doped region being disposed in contact with a side of the second doped region away from the back side, either of the second heavy doped region and the second doped region being an N-type doped region, and a doping concentration of the second heavy doped region being greater than a doping concentration of the second doped region; a first passivation layer having fixed negative charges and formed on the side of the first doped region away from the first heavily doped region; and a second passivation layer having fixed positive charges and formed on the side of the second doped region away from the second heavily doped region. The solar cell structure has a high conversion efficiency.

## Description

### Technical Field

The present disclosure relates to the technical field of photovoltaic, in particular to a solar cell structure and a manufacturing method thereof.

### Background

With low-carbon energy and green environment becoming the general course of global development, China urgently needs to use new energy to replace traditional fossil fuels. Solar energy has become one of the most promising energy sources because of its advantages of safety, reliability, wide distribution and low cost. Compared with the current mainstream passivated emitter and rear contact (PERC) crystalline silicon solar technology, interdigitated back-contacted (IBC) solar cells have clear advantages. The most prominent characteristic of the interdigitated back-contacted cell is that an emitter and metal contact are located on the back of the battery, a front side of the battery is not shielded by metal electrodes, so it has higher short-circuit current Jsc, and a wider metal grid line is allowable for the back to reduce the series resistance Rs and improve the filling factor FF. Moreover, this kind of cell with no shading on the front side not only has a high conversion efficiency, but also looks more beautiful, which is highly sought after by the European roof market and becomes a research hotspot of the next generation technological revolution.

In XBC cells based on the interdigitated back-contacted solar cells, PN junctions and electrodes are on the back, which leads to the photo-generated carriers generated inside the cells, especially on the front side, needing to be transported to the thickness of a whole silicon wafer before they can be separated and collected, so passivation of the back side of the cells is critical. However, at present, the back passivation layer in the interdigitated back-contacted solar cells easily leads to the reduction of conversion efficiency.

### Summary

The main purpose of the present disclosure is to provide a solar cell structure and a manufacturing method thereof, so as to solve the problem of low conversion efficiency of the interdigitated back-contacted solar cell in the prior art.

To achieve the above object, according to one aspect of the present disclosure, a solar cell structure is provided including a semiconductor substrate having a first doped region and a second doped region formed on a back side of the semiconductor substrate; a first heavily doped region formed in the semiconductor substrate, the first heavily doped region being disposed in contact with a side of the first doped region away from the back side, either of the first heavily doped region and the first doped region being a P-type doped region, and a doping concentration of the first heavily doped region being greater than a doping concentration of the first doped region; a second heavily doped region formed in the semiconductor substrate, the second heavily doped region being disposed in contact with a side of the second doped region away from the back side, either of the second heavily doped region and the second doped region being an N-type doped region, and a doping concentration of the second heavily doped region being greater than a doping concentration of the second doped region; a first passivation layer formed on the side of the first doped region away from the first heavily doped region, the first passivation layer having fixed negative charges; and a second passivation layer at least formed on the side of the second doped region away from the second heavily doped region, the second passivation layer having fixed positive charges.

Alternatively, the back side of the semiconductor substrate is provided with a recess, the first doped region is formed in a region corresponding to the recess in the back side, the second doped region is formed in a region on either side of the recess in the back side, and the first passivation layer is formed in the recess, the recess preferably having a depth of 10 to 100 µm.

Alternatively, a part of the second passivation layer is formed on the side of the second doped region away from the second heavily doped region, and another part of the second passivation layer is formed on a side of the first passivation layer away from the first doped region.

Alternatively, the doping concentrations of the first doped region and the second doped region are independently selected from 10¹⁸ to 10²⁰ cm⁻³; and the doping concentrations of the first heavily doped region and the second heavily doped region are independently selected from 10²⁰ to 10²² cm⁻³.

Alternatively, the first doped region and the second doped region are polysilicon doped structures, the solar cell structure further includes a tunneling oxide layer covering either of side surfaces of the polysilicon doped structures away from the first passivation layer and the second passivation layer and preferably having a thickness of 1 to 2 nm.

Alternatively, the first passivation layer includes any one or more of an alumina layer, a gallium oxide layer, a stack of alumina and silicon nitride, and a stack of gallium oxide and silicon nitride.

Alternatively, the second passivation layer includes any one or more of a silicon nitride layer and a hydrogenated amorphous silicon layer.

Alternatively, the semiconductor substrate is a silicon substrate, and the solar cell structure further includes a silicon dioxide layer covering the back side, a part of the silicon dioxide layer being located between the first doped region and the first passivation layer, another part of the silicon dioxide layer being located between the second doped region and the second passivation layer, and the silicon dioxide layer preferably having a thickness of 2 to 10 nm.

Alternatively, the solar cell structure further includes: a front surface field formed on a front side of the semiconductor substrate, the semiconductor substrate being a doped substrate, the front surface field is of the same doping type as the doped substrate, and a doping concentration of the front surface field being greater than a doping concentration of the doped substrate; or a front floating junction formed on a front side of the semiconductor substrate, the semiconductor substrate being a doped substrate, the front floating junction is of an opposite doping type to the doped substrate, and a doping concentration of the front floating junction being greater than a doping concentration of the doped substrate.

According to another aspect of the present disclosure, a manufacturing method of the solar cell structure is provided including: a first doped region and a second doped region are formed on a back side of a semiconductor substrate; a first heavily doped region is in contact with a side of the first doped region away from the back side and a second heavily doped region is in contact with a side of the second doped region away from the back side in the semiconductor substrate, wherein either of the first heavily doped region and the first doped region is a P-type doped region, either of the second heavily doped region and the second doped region is an N-type doped region, and a doping concentration of the first heavily doped region is greater than a doping concentration of the first doped region, and a doping concentration of the second heavily doped region is greater than a doping concentration of the second doped region; forming a first passivation layer on a side of the first doped region away from the first heavily doped region, the first passivation layer having fixed negative charges; and forming a second passivation layer at least on a side of the second doped region away from the second heavily doped region, the second passivation layer having fixed positive charges.

Alternatively, forming the first doped region and the second doped region includes: depositing an intrinsic polysilicon material is deposited on the back side of the semiconductor substrate, and the polysilicon material is subjected to N-type ion diffusion and P-type ion diffusion, to form the first doped region and the second doped region; or in situ doping is performed on the back side of the semiconductor substrate using N-type ions and P-type ions, respectively, to form the first doping region and the second doping region, wherein the semiconductor substrate is a polycrystalline silicon substrate.

Alternatively, prior to forming the first doped region and the second doped region, the manufacturing method further includes: a tunneling oxide layer is formed on the back side of the semiconductor substrate, after forming the first passivation layer and the second passivation layer, the first passivation layer and a part of the tunneling oxide layer are located on either side of the first doped region, and the second passivation layer and another part of the tunneling oxide layer are located on either side of the second doping region.

Alternatively, prior to forming the first doped region and the second doped region, the manufacturing method further includes: the back side of the semiconductor substrate is etched to form a recess; and the first doped region is formed in a region in the back side corresponding to the recess, and the second doped region is formed in a region in the back side on either side of the recess, in forming the first doped region and the second doped region.

Alternatively, forming the first passivation layer and the second passivation layer includes: the back side of the semiconductor substrate is covered with a silicon dioxide layer such that a part of the silicon dioxide layer covers a bottom surface and an inner wall of the recess and is in contact with the first doped region, and another part of the silicon dioxide layer is in contact with the second doped region; the first passivation layer is formed in the recess; and surfaces of the first passivation layer and the silicon dioxide layer are covered with the second passivation layer.

Alternatively, forming the first heavily doped region and the second heavily doped region includes: selective emitter laser doping are performed on the back side of the semiconductor substrate with P-type ions to form the first heavily doped region, preferably using a picosecond laser of 355 nm with a pulse width of 10-20 ps and a working frequency of 10-80 MHz; and selective emitter laser doping are performed on the back side of the semiconductor substrate with N-type ions to form the second heavily doped region, preferably using a nanosecond laser of 532 nm with a pulse width of 6-20 ns and a working frequency 50-200 KHz.

In application of the technical solutions of the present disclosure, there is provided a solar cell structure including a semiconductor substrate having a first doped region and a second doped region formed on a back side of the semiconductor substrate. The solar cell structure also includes a first heavily doped region formed in the semiconductor substrate, the first heavily doped region being disposed in contact with a side of the first doped region away from the back side, either of the first heavily doped region and the first doped region being a P-type doped region, and a doping concentration of the first heavily doped region being greater than a doping concentration of the first doped region; and a second heavy doped region formed in the semiconductor substrate, the second heavy doped region being disposed in contact with a side of the second doped region away from the back side, either of the second heavy doped region and the second doped region being an N-type doped region, and a doping concentration of the second heavy doped region being greater than a doping concentration of the second doped region. It is possible to enhance the ohmic contact of the device, reduce the series resistance and reduce the carrier recombination probability by adding the first heavily doped region and the second heavily doped region with higher doping concentration to the above first doped region and the above second doped region. Meanwhile, since the solar cell structure also includes a first passivation layer having fixed negative charges and a second passivation layer having fixed positive charges, the first passivation layer is formed on the side of the first doped region away from the first heavily doped region, and the second passivation layer is at least formed on the side of the second doped region away from the second heavily doped region, thereby achieving the partition passivation of the PIN region, improving the collection efficiency of photo-generated carriers, and further improving the conversion efficiency of the solar cell structure.

### Brief Description of the Drawings

The accompanying drawings, forming part of the present disclosure, serve to provide a further understanding for the present disclosure, and the exemplary embodiments of the present disclosure as well as the illustrations thereof serve to explain the present disclosure and do not constitute an undue limitation of the present disclosure. In the drawings:
Fig. 1 shows a structural schematic diagram of a solar cell structure provided according to an embodiment of the present disclosure; and
Fig. 2 shows a structural schematic diagram of another solar cell structure provided according to an embodiment of the present disclosure.

The above drawings include the following reference signs:
1. semiconductor substrate; 2. front surface field; 3. anti-reflection coating; 4. first doped region; 41. boron-doped polysilicon; 5. first heavily doped region; 6. second doped region; 61. phosphorus-doped polysilicon; 7. second heavily doped region; 8. silicon dioxide layer; 9. first passivation layer; 10. second passivation layer; 11. second electrode; 12. first electrode; 13. tunneling oxide layer.

### Detailed Description of the Embodiments

It should be noted that the embodiments in the present disclosure and the features in the embodiments can be combined with each other without conflict. The present disclosure will be described in detail below with reference to the accompanying drawings and in conjunction with embodiments.

In order to enable a person skilled in the art to better understand the solution of the present disclosure, the technical solutions in the embodiments of the present disclosure will be clearly and completely described below in conjunction with the accompanying drawings in the embodiments of the present disclosure. Obviously, the described embodiments are only a part of the embodiments of the present disclosure, and not all of them. Based on the embodiments of the present disclosure, all other embodiments obtained by those ordinarily skilled in the art without exerting creative effort fall within the scope of protection of the present disclosure.

It should be noted that the terms "first", "second" and the like in the description and claims as well as the above drawings of the present disclosure are used to distinguish similar objects and are not necessarily used to describe a specific order or sequence. It should be understood that the data thus used may be interchanged under appropriate circumstances, so that the embodiments of the present disclosure described herein can be implemented. In addition, the terms "including" and "having" and any variations of them, intended to cover non-exclusive inclusions, for example, processes, methods, systems, products, or devices including a series of steps or units need not be limited to those clearly listed, but may include other steps or units that are not clearly listed or inherent to such processes, methods, products, or devices.

As mentioned in the background, the most prominent characteristic of the interdigitated back-contacted battery is that the emitter and metal contact are on the back side of the battery, while it is precisely because the PN junction and electrodes are on the back, which will lead to the photo-generated carriers generated inside the cell, especially on the front side, needing to be transported to the thickness of a whole silicon wafer before they can be separated and collected. However, the current backside passivation layer in the interdigitated back-contacted solar cells easily leads to the reduction of conversion efficiency.

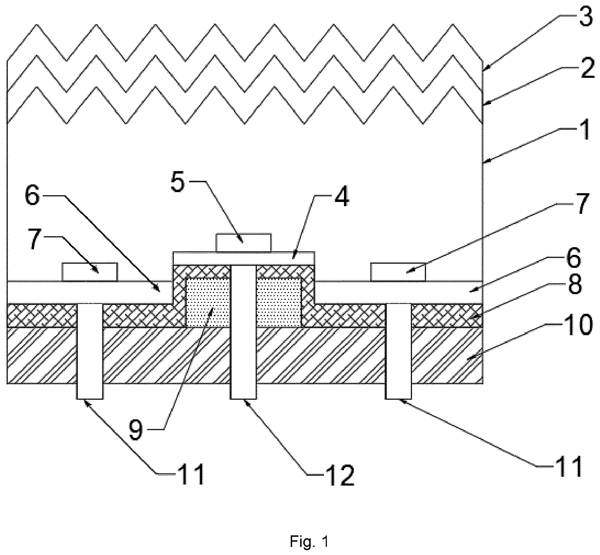

In order to solve the above technical problems, the applicant of the present disclosure proposes a solar energy structure, as shown in Fig. 1, which includes a semiconductor substrate 1, a first heavily doped region 5, a second heavily doped region 7, a first passivation layer 9 and a second passivation layer 10. A first doped region 4 and a second doped region 6 are formed on a back side of the semiconductor substrate 1. The first heavily doped region 5 is formed in the semiconductor substrate 1, and the first heavily doped region 5 is disposed in contact with a side of the first doped region 4 away from the back side, the first heavily doped region 5 and the first doped region 4 are both P-type doped regions, and a doping concentration of the first heavily doped region 5 is greater than that of the first doped region 4. The second heavily doped region 7 is formed in the semiconductor substrate 1, and the second heavily doped region 7 is disposed in contact with a side of the second doped region 6 away from the back side, the second heavily doped region 7 and the second doped region 6 are both N-type doped regions, and a doping concentration of the second heavily doped region 7 is greater than that of the second doped region 6. The first passivation layer 9 is formed on the side of the first doped region 4 away from the first heavily doped region 5, and the first passivation layer 9 has fixed negative charges. The second passivation layer 10 is formed at least on the side of the second doped region 6 away from the second heavily doped region 7, and the second passivation layer 10 has fixed positive charges.

In the above structure, since the first heavily doped region 5 and the second heavily doped region 7 are respectively provided in contact with the first doped region 4 and the second doped region 6, the doping concentration of the first heavily doped region 5 is greater than that of the first doped region 4, the doping concentration of the second doped region 7 is greater than that of the second doped region 6. This arrangement enhances the ohmic contact of the device, reduces the resistance value of the series resistance in the device, further reduces the recombination rate of carriers, and can improve the short-circuit current, which is beneficial to improving the conversion power of the solar cell.

In the above structure, since the first passivation layer 9 and the second passivation layer 10 are further provided, the first doped region 4 and the second doped region 6 are respectively passivated by partitions, where the first passivation layer 9 carries a large number of negative charges, the second passivation layer 10 has a large number of positive charges, which can avoid the phenomenon that an aluminum oxide passivation layer with negative charges forms an inversion layer in the N-type doped region in the conventional passivation mode, which is not conducive to electron collection, thereby improving the collection rate of photo-generated carriers, playing an excellent field passivation effect, and further improving the conversion efficiency of the solar cell structure.

In some embodiments, the back side of the above semiconductor substrate 1 is provided with a recess, the first doped region 4 is formed in a region corresponding to the recess in the back side, the second doped region 6 is formed in a region on either side of the recess in the back side, and the first passivation layer 9 is formed in the recess, the recess preferably has a depth of 10 µm to 100 µm. Since the P-type doped region and the N-type doped region in the interdigitated back-contacted solar cell are arranged in the battery at intervals in an interdigital shape, the phenomenon of battery leakage is prone to occur. In this embodiment, the P-type doped region and the N-type doped region are physically isolated by the formation of height difference by opening recesses, thereby avoiding the generation of leakage.

In some optional embodiments, the semiconductor substrate 1 is a silicon substrate, and since the position of the PN junction of the interdigitated back-contacted solar cell is at the back side of the cell, and the photo-generated carriers are mainly generated on the front surface of the cell, they need to pass through the semiconductor substrate 1 with a certain thickness to reach the emitter at the back side. In order to reduce the recombination of photo-generated carriers, it is necessary for the substrate to have a long minority carrier diffusion length, so high-quality monocrystalline silicon wafer is used to prepare high-efficiency interdigitated back-contacted solar cells.

The substrate silicon wafer of the semiconductor substrate 1 may be either a P-type silicon wafer or an N-type silicon wafer. After selecting different types of substrate silicon wafers, their doping in cells will be different. If N-type silicon wafer is selected, boron is doped in a certain area on the back side of the cell to form a P⁺ region, which serves as the emitter. If a P-type silicon wafer is selected, phosphorus is doped in a certain area on the back side of the cell to form an N⁺ region, which serves as the emitter and forms a PN junction with the silicon wafer substrate. Compared with P-type silicon wafers, the N-type silicon wafers have the advantages of high minority carrier lifetime, no light attenuation and good weak light performance, but the P-type silicon wafers have advantages in cost.

In some optional embodiments, a part of the second passivation layer 10 is formed on the side of the second doped region 6 away from the second heavily doped region 7, and another part of the second passivation layer 10 is formed on a side of the first passivation layer 9 away from the first doped region 4. The second doped region 6 is an N-type doped region. Since the second passivation layer 10 has a higher fixed positive charge density, the part of the second passivation layer 10 formed on the side of the second doped region 6 away from the second heavily doped region 7 can show remarkable field effect passivation characteristics by shielding minority electrons on the surface of N-type doped region. Also because the first passivation layer 9 is provided between the first doped region 4 and the second passivation layer 10, another part of the second passivation layer 10 formed on the side of the first passivation layer 9 away from the first doped region 4 avoids the phenomenon that the second passivation layer 10 with positive charges forms an inversion layer in the P-type doped region, which is unfavorable for electron collection, thereby improving the collection rate of photo-generated carriers, achieving excellent field passivation effect, and further improving the conversion efficiency of the solar cell structure.

In some optional embodiments, the doping concentrations of the first doped region 4 and the second doped region 6 in the solar cell structure are independently selected from 10¹⁸ cm⁻³ to 10²⁰ cm⁻³; and the doping concentrations of the first heavily doped region 5 and the second heavily doped region 7 are independently selected from 10²⁰ cm⁻³ to 10²² cm⁻³. By providing that the doping concentration of the first heavily doped region 5 is higher than that of the first doped region 4, the doping concentration of the second heavily doped region 7 is higher than that of the second doped region 6, the ohmic contact of the device is enhanced, the resistance value of the series resistor in the device is reduced, the recombination rate of carriers is further reduced, and the short-circuit current can be increased, which is beneficial to improving the conversion power of the solar cell.

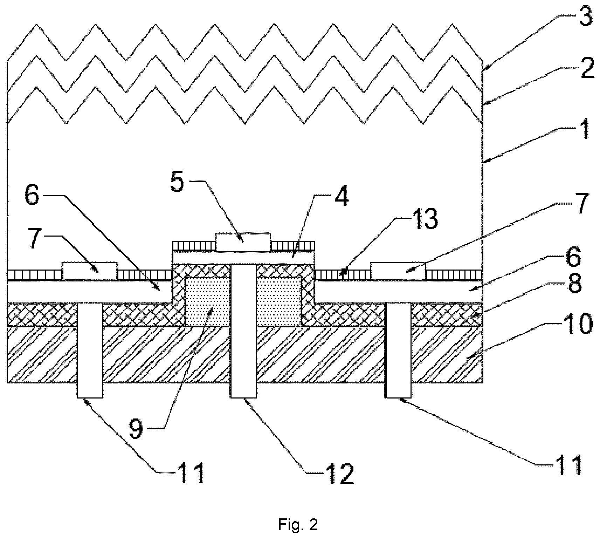

In some optional embodiments, as shown in Fig. 2, the first doped region 4 and the second doped region 6 are polysilicon doped structures, and the solar cell structure further includes a tunneling oxide layer 13 covering either of side surfaces of the polysilicon doped structures away from the first passivation layer 9 and the second passivation layer 10, preferably having a thickness of 1 nm to 2 nm. The polysilicon doped structures and the tunneling oxide layer 13 together constitute a back passivation contact structure of the solar cell, which makes the solar cell have lower carrier recombination rate, better contact, and thus higher conversion efficiency.

As an example, the first doped region 4 is boron-doped polysilicon 41 and the second doped region 6 is phosphorus-doped polysilicon 61, as shown in Fig. 2.

The tunneling oxide layer 13 may be a silicon oxide layer. It can make majority carriers tunneling into the polysilicon doped structures and block minority carriers recombination. The good passivation effect of ultra-thin silicon oxide and heavily doped region makes the surface energy band of silicon wafer bend, thereby forming field passivation effect. The probability of electron tunneling is greatly increased, the contact resistance is decreased, and the open circuit voltage and short circuit current of the cell are improved, and thus the conversion efficiency of the cell is improved.

In some optional embodiments, the first passivation layer 9 includes any one or more of an alumina layer, a gallium oxide layer, a stack of alumina and silicon oxide, and a stack of gallium oxide and silicon nitride.

In some optional embodiments, the second passivation layer 10 includes any one or more of a silicon nitride layer and a hydrogenated amorphous silicon layer.

In some optional embodiments, the solar cell structure further includes a silicon dioxide layer 8, the silicon dioxide layer 8 is covered on the back side, a part of the silicon dioxide layer 8 is located between the first doped region 4 and the first passivation layer 9, and another part of the silicon dioxide layer 8 is located between the second doped region 6 and the second passivation layer 10, preferably the thickness of the silicon dioxide layer 8 is 2 nm to 10 nm. By introducing the silicon dioxide layer 8 between the first doped region 4 and the first passivation layer 9 and between the second doped region 6 and the second passivation layer 10, since there is a certain content of hydrogen in the passivation layer, the hydrogen content of alumina layer is about 2% to 4%. When the passivability of the passivation layer is activated during annealing, the crystallinity of silicon surface changes from microcrystalline amorphous mixing to polycrystalline. Meanwhile, hydrogen ions in the passivation layer will diffuse to the interface. The silicon dioxide layer 8 can effectively prevent excessive hydrogen ions from penetrating into the semiconductor silicon substrate, thereby avoiding serious photothermal attenuation LeTTD effect.

In some implementable embodiments, the above solar cell structure further includes a front surface field 2 formed on the front side of the semiconductor substrate 1, which is a doped substrate, and the front surface field 2 is of the same doping type as the doped substrate.

The doping concentration of the front surface field 2 is greater than that of the semiconductor substrate 1, and a concentration difference between the front surface field 2 and the semiconductor substrate 1 is beneficial to move carriers to the back side of the solar cell and collect them on the back side.

In other embodiments, the above solar cell structure further includes a front floating junction (not shown) formed on the front side of the semiconductor substrate 1, which is a doped substrate, the front floating junction is of an opposite doping type to the doped substrate.

A doping concentration of the front floating junction is greater than that of the semiconductor substrate 1, and a concentration difference between the front floating junction and the semiconductor substrate 1 serves to assist the separation of carriers, thereby enhancing the carrier collection efficiency.

In some optional embodiments, the solar cell structure further includes an anti-reflection coating 3 disposed on a side of the front surface field 2 or the front floating junction away from the semiconductor substrate 1, i.e., disposed on the front side of the semiconductor substrate 1, as shown in Figs. 1 and 2. The anti-reflection coating 3 can effectively reduce the reflectivity of the contact plates, so that more light is absorbed by the silicon substrate.

In some optional embodiments, a first electrode 12 in contact with the first doped region 4 and a second electrode 11 in contact with the second doped region 6 are provided on the back side of the semiconductor substrate 1. As shown in Figs. 1 and 2, the first electrode 12 runs sequentially through the second passivation layer 10, the first passivation layer 9, and the silicon dioxide layer 8 to the first doped region 4, and the second electrode 11 runs sequentially through the second passivation layer 10 and the silicon dioxide layer 8 to the second doped region 6.

In order to form the above solar cell structure, according to another aspect of the present disclosure, a manufacturing method of a solar cell structure is provided including: a first doped region and a second doped region are formed on a back side of a semiconductor substrate; a first heavily doped region is formed in contact with a side of the first doped region away from the back side of the semiconductor substrate and a second heavily doped region is formed in contact with a side of the second doped region away from the back side of the semiconductor substrate, wherein either of the first heavily doped region and the first doped region is a P-type doped region, either of the second heavily doped region and the second doped region is an N-type doped region, and a doping concentration of the first heavily doped region is greater than a doping concentration of the first doped region, and a doping concentration of the second heavily doped region is greater than a doping concentration of the second doped region; forming a first passivation layer on the side of the first doped region away from the first heavily doped region, the first passivation layer having fixed negative charges; and forming a second passivation layer at least on the side of the second doped region away from the second heavily doped region, the second passivation layer having fixed positive charges.

Exemplary embodiments of the manufacturing method of the solar cell structure provided according to the present disclosure will be described in more detail below. However, these exemplary embodiments may be implemented in a number of different forms and should not be construed as being limited only to the embodiments set forth herein. It should be understood that these embodiments are provided to make the disclosure of the present application thorough and complete and to fully convey the idea of these exemplary embodiments to those of ordinary skill in the art.

In some implementable ways, the semiconductor substrate is a silicon substrate, a surface of a silicon wafer of the silicon substrate is subjected to a texturing treatment to remove a damaged layer on the surface of the silicon wafer and reduce recombination centers on the surface of the silicon wafer, a texturing surface is formed on the substrate, the texturing surface can increase sunlight absorption and reduce reflection, so as to increase the short-circuit current, which is beneficial to improving the conversion efficiency of the solar cell.

The semiconductor silicon substrate can be an N-type silicon substrate or a P-type silicon substrate.

In some optional embodiments, a resistivity of the semiconductor substrate is 0.3 Ω• cm to 3 Ω• cm.

In some optional embodiments, the semiconductor substrate has a thickness of 150 µm to 180 µm.

In some optional embodiments, the silicon substrate is back polished. After the silicon wafer is back polished, the back reflectivity of light is increased and the transmission loss is reduced by means of the specular reflection principle, thereby increasing the output current. In this regard, due to a small specific surface area of the back side after polishing, the recombination rate of the back surface decreases and the minority carrier lifetime of the silicon wafer is significantly improved.

In some optional embodiments, an intrinsic polysilicon material is deposited on the back side of the semiconductor substrate, and the polysilicon material is subjected to N-type ion diffusion and P-type ion diffusion, to form the first doped region and the second doped region; or in situ doping is performed on the back side of the semiconductor substrate using N-type ions and P-type ions, respectively, to form the first doping region and the second doping region. The semiconductor substrate is a polycrystalline silicon substrate.

In some optional embodiments, a boron-doped first doped region and a phosphorus-doped second doped region are respectively formed, and the first doped region and the second doped region are cross-arranged in the back side region of the semiconductor substrate. Further alternatively, an effective doping concentration of the first doped region and the second doped region is 10¹⁸ cm⁻³ to 10²⁰ cm⁻³, and the corresponding widths of the first doped region and the second doped region are 400 µm to 2000 µm, which in this embodiment can effectively reduce the compound loss in the carrier diffusion process and thus improve the conversion efficiency of the solar cell.

A doping thickness of the first doped region and the second doped region are both 60 nm to 200 nm, and the first doped region and the second doped region can be formed by low pressure chemical vapor deposition (LPCVD), plasma enhanced chemical vapor deposition (PECVD), physical vapor deposition (PVD), atmospheric pressure chemical vapor deposition (APCVD) and the like.

In some optional embodiments, the first doped region and the second doped region are formed by screen printing and thermal propulsion. That is, the boron-containing slurry is printed in the first doped region by screen printing, and the phosphorus-containing slurry is printed in the second doped region, and then the boron atoms and phosphorus atoms in the slurry are pushed into the semiconductor silicon substrate under high temperature conditions to form the first doped region and the second doped region.

In some optional embodiments, the first doped region and the second doped region are formed using a mask and two ion implantations. That is to say, the unnecessary areas are covered by the mask, and the corresponding boron atoms and phosphorus atoms are implanted into the semiconductor silicon substrate by an ion cavity, and then the corresponding first doped and second doped areas are formed by a high temperature advancing process.

In some optional embodiments, the first doped region and the second doped region are formed by thermal diffusion. The gas used to form the first doped region is boron tribromide or boron trichloride, and the gas used to form the second doped region is phosphorus oxychloride. Further alternatively, in the process of thermal diffusion, masking and cleaning process are performed twice. That is to say, when the first doped region is formed, the second doped region is covered with the mask, and then boron tribromide or boron trichloride is introduced for thermal diffusion at a diffusion temperature of 900°C to 1100°C, and finally the mask is cleaned. When the second doped region is formed, the first doped region is covered with the mask, and then phosphorus oxychloride is introduced for thermal diffusion at a diffusion temperature of 700°C to 900 °C, and finally the mask is cleaned.

In some optional embodiments, prior to forming the first doped region and second doped region, the manufacturing method of the solar cell structure further includes: a tunneling oxide layer is formed on the back side of the semiconductor substrate, wherein the first passivation layer and a part of the tunneling oxide layer are located on either side of the first doped region, and the second passivation layer and another part of the tunneling oxide layer are located on either side of the second doping region after forming the first passivation layer and the second passivation layer.

The tunneling oxide layer can form a back passivation contact structure of the solar cell together with the polysilicon substrate, thereby forming full-area passivation of the back side, which further improves the conversion efficiency of the solar cell.

In some optional embodiments, the tunneling oxide layer is a silicon dioxide structure with a thickness of 1 cm to 2 cm.

The tunneling oxide layer can be formed by using thermal oxidation, ozone oxidation, wet oxidation, low pressure chemical vapor deposition (LPCVD), plasma enhanced chemical vapor deposition (PECVD), physical vapor deposition (PVD), atmospheric pressure chemical vapor deposition (APCVD) and other methods.

In some optional embodiments, prior to forming the first doped region and the second doped region, the manufacturing method of the solar cell structure further includes: the back side of the semiconductor substrate is etched to form a recess; and the first doped region is formed in a region in the back side corresponding to the recess, and the second doped region is formed in a region in the back side on either side of the recess, in forming the first doped region and the second doped region.

Since the first doped region and the second doped region are cross-arranged, the recess can be formed by laser slotting to avoid battery leakage, a first doped region is further formed in the recess so that there is a certain height difference between the first doped region and the second doped region, so as to carry out effective physical isolation. Moreover, a gap area between the first doped region and the second doped region isolated by recesses is small, which can make the surface have good passivation effect, thereby avoiding the recombination of minority carriers, too wide may lead to the waste of the effective area of the back-contact battery, and effective carriers are difficult to be collected, so that the cell performance is reduced.

In some optional embodiments, the recess has a depth of 10 µm to 100 µm.

In some optional embodiments, forming the first passivation layer and the second passivation layer includes: the back side of the semiconductor substrate is covered with a silicon dioxide layer such that a part of the silicon dioxide layer covers a bottom surface and an inner wall of the recess and is in contact with the first doped region, and another part of the silicon dioxide layer is in contact with the second doped region; the first passivation layer is formed in the recess; and surfaces of the first passivation layer and the silicon dioxide layer are covered with the second passivation layer.

The silicon dioxide layer can be formed by thermal oxidation, low pressure chemical vapor deposition (LPCVD) and plasma enhanced chemical vapor deposition (PECVD). Alternatively, the silicon dioxide layer has a thickness of 2 nm to 10 nm.

The silicon-oxygen tetrahedral structure in the silicon dioxide layer has good matching with the silicon in the semiconductor silicon substrate, which can provide excellent passivation and protection, and the thin oxide layer can prevent excessive hydrogen ions from penetrating into the semiconductor silicon substrate in the subsequent deposition process, thereby causing serious photothermal attenuation LeTID effect.

In some optional embodiments, when the first passivation layer is formed, the second doped region is covered with the mask, a hollowed-out region of the mask is overlapped with the first doped region, and then a passivation film corresponding to the first doped region is deposited on the hollowed-out region to form the first passivation layer.

The first passivation layer is a negatively charged passivation layer, and the first passivation layer may include a single-layer or multi-layer stacked structure such as alumina, gallium oxide, combination of alumina and silicon nitride, combination of gallium oxide and silicon nitride, etc.

In some optional embodiments, when forming the second passivation layer, the first doped region is covered with the mask, a hollowed-out region is overlapped with the second doped region, and then a passivation film corresponding to the second doped region is deposited on the hollowed-out region to form the second passivation layer.

The second passivation layer is a positively charged passivation layer, and the second passivation layer can include a single-layer or multi-layer stacked structure such as silicon oxide, silicon nitride and hydrogenated amorphous silicon.

In some optional embodiments, thicknesses of the first passivation layer and the second passivation layer are both 60 nm to 200 nm.

In some optional embodiments, forming the first heavily doped region and the second heavily doped region includes: selective emitter laser doping is performed on the back side of the semiconductor substrate with P-type ions to form the first heavily doped region, preferably using a picosecond laser of 355 nm with a pulse width of 10-20 ps and a working frequency of 10-80 MHz; and selective emitter laser doping is performed on the back side of the semiconductor substrate with N-type ions to form the second heavily doped region, preferably using a nanosecond laser of 532 nm with a pulse width of 6-20 ns and a frequency 50-200 KHz.

In some optional embodiments, the first doped region and the second doped region are heavily doped with selective emitter (SE) laser at a doping concentration of 10²⁰ to 10²² cm⁻³. This step introduces the mature SE technology in PERC into the back contact cell to form a heavily doped region, which enhances ohmic contact, reduces series resistance and reduces carrier recombination probability.

In some optional embodiments, since the boron emitter in the first doped region and the phosphorus emitter in the second doped region have different characteristics, different lasers are used for doping to form the first heavily doped region and the second heavily doped region. The phosphorus emitter generally adopts 532nm green light at nanosecond level. Boron emitter has low surface concentration and a relatively deep junction, and the solubility of boron in borosilicate glass is greater than that of silicon, so larger laser energy is needed to make boron diffuse to silicon wafer. However, when nanosecond laser energy is too large, silicon wafer will be damaged, so picosecond laser is needed for boron doping.

In some optional embodiments, after forming the first heavily doped region and the second heavily doped region, the manufacturing method further includes forming a front surface field or a positive floating junction on a front side of the semiconductor substrate.

In some optional embodiments, when the semiconductor substrate is P-type doped substrate, the front surface field is a boron-doped P⁺-type region, and when the semiconductor substrate is N-type doped substrate, the front surface field is a phosphorus-doped N⁺-type region.

In some optional embodiments, when the semiconductor substrate is P-type doped substrate, the frontal floating junction is an N-type region formed by phosphorus doping, and when the semiconductor substrate is N-type doped substrate, the frontal floating junction is a P-type region formed by boron doping.

In addition, combination of screen printing and thermal propulsion, ion implantation and diffusion can be used to form the front surface field or front floating junction.

In some optional embodiments, after the front surface field or the positive floating junction is formed, an anti-reflection coating is formed on the side of the front surface field or the front floating junction away from the semiconductor substrate, and the anti-reflection coating is disposed on the front surface of the semiconductor substrate, which can effectively reduce the reflectivity of the contact plate, so that more light is absorbed by the semiconductor silicon substrate, energy waste is reduced, thereby improving the conversion efficiency of the solar cell.

The anti-reflection coating may include magnesium fluoride, silicon nitride, silicon oxide and other materials having anti-reflection function.

In some optional embodiments, the anti-reflection coating has a thickness of 60 to 150 nm.

In some optional embodiments, the anti-reflection coating has a refractive index of 1.8 to 2.5.

In some optional embodiments, the manufacturing method of the solar cell structure further includes back metallization, i.e., printing the same or different kinds of slurry on the sides of the first doped region and the second doped region away from the semiconductor silicon substrate, respectively, to form the back metal electrode.

The metal electrode can be formed by laser transfer printing, screen printing, electroplating and the like, and the slurry can include any one or more of silver slurry, penetrating aluminum slurry and silver-aluminum slurry.

In some optional embodiments, after forming the above described solar cell structure, the manufacturing method further includes sintering to form the final solar cell structure.

### Embodiment 1

The embodiment provides a manufacturing method of a solar cell structure, which includes:
S1, performing a texture treatment on a P-type semiconductor silicon substrate to remove a damaged layer on a surface of a silicon wafer, wherein the P-type semiconductor silicon substrate has a resistivity of 0.8 Ω• cm and a thickness of 160 µm;
S2: etching the back side of the P-type semiconductor silicon substrate to form a recess P region and an N region outside the recess, the recess having a depth of 20 µm, printing boron-containing slurry in the P region by screen printing plus thermal propulsion, pushing boron away from P-type silicon substrate to form a P region under high temperature advancement, printing phosphorus-containing slurry in an N region, and pushing phosphorus atoms into P-type silicon substrate to form an N region under high temperature advancement, wherein an effective doping concentration of the P region and the N region is 10¹⁹ cm⁻³, and a width of the P region is 600 µm and a width of the N region is 1000 µm;
S3: selecting a 355 nm picosecond laser with a pulse width of 10 to 20 ps and a frequency of 10-80 MHz to dope the P region with a doping concentration of 10²¹ cm⁻³ to form a heavily doped P⁺ region; and selecting a 532 nm nanosecond laser with a pulse width of 6 to 20 ns and a frequency of 50-200 KHz to dope the N region with a doping concentration of 10²¹ cm⁻³ to form a heavily doped N⁺ region;
S4: introducing boron trichloride and oxygen into the front side of the P-type semiconductor silicon substrate, and forming a front surface field (FSF) by thermal diffusion at a high temperature of 1050°C, a doping concentration of the front surface field being greater than that of the semiconductor silicon substrate;
S5: depositing a 5 nm silicon dioxide layer by plasma enhanced chemical vapor deposition (PECVD);
S6: covering the N region with a mask so that a hollowed-out region is overlapped with the P region, and then depositing an alumina plus silicon nitride passivation layer by plasma enhanced chemical vapor deposition (PECVD), the alumina having a thickness of 10 nm, and the silicon nitride having a thickness of 80 nm;
S7: covering the P region with a mask so that a hollowed-out region is overlapped with the N region, and then depositing a silicon nitride passivation layer by plasma enhanced chemical vapor deposition (PECVD), the silicon nitride having a thickness of 100 nm;
S8: depositing a silicon nitride anti-reflection coating with a thickness of 80 nm and a refractive index of 2.3 by plasma enhanced chemical vapor deposition (PECVD);
S9: printing a silver slurry on both the N region and the P region of the back side of the P-type semiconductor silicon substrate to form an N region electrode and a P region electrode; and
S10: sintering.

### Comparative Example 1

This comparative example differs from Embodiment 1 in that there is no step S4, i.e., no front surface field.

### Comparative Example 2

This comparative example differs from Embodiment 1 in that there is no step S5, i.e., there is no silicon dioxide layer on the back side.

### Comparative Example 3

This comparative example differs from Embodiment 1 in that there is no step S3, i.e., there is no heavily doped regions on the first doped region and the second doped region on the back side.

### Comparative Example 4

This comparative example differs from Embodiment 1 in that there are no steps S6 and S7, i.e., the first doped region and the second doped region on the back side are not passivated by partition. Instead, plasma enhanced chemical vapor deposition (PECVD) was used to sequentially deposit alumina and silicon nitride passivation films on the back of semiconductor silicon substrate. The thickness of alumina was 10 nm, and the thickness of silicon nitride was 80 nm.

Performance tests were performed on the solar cell structures in Embodiment 1 and Comparative Examples 1 to 4, and electrical performance data as shown in Table 1 were obtained.

**TABLE 1**

| | Uoc(V) | Isc(A) | FF(%) | NCell |
|---|---|---|---|---|
| Embodiment 1 | 0.6961 | 13.539 | 81.61 | 23.30% |
| Comparative Example 1 | 0.6959 | 13.536 | 81.60 | 23.28% |
| Comparative Example 2 | 0.6960 | 13.541 | 81.63 | 23.30% |
| Comparative Example 3 | 0.6945 | 13.521 | 81.35 | 23.14% |
| Comparative Example 4 | 0.6941 | 13.509 | 81.25 | 23.08% |

In the above table, Uov is the open circuit voltage, Isc is the short circuit current, and FF is the fill factor.

As can be seen from the above table, in the electrical performance data, Embodiment 1 has different degrees of efficiency advantages compared with Comparative Examples 1, 3 and 4, indicating that front surface field FSF, heavy doping and partition passivation have advantages in open circuit voltage, short circuit current and conversion efficiency of cells.

Further, performance tests were performed on the solar cell structures in Embodiment 1 and Comparative Example 2, and photothermal attenuation LeTID data (2.5 kwh) as shown in Table 2 were obtained.

**TABLE 2**

| | Ncell (Initial) | Ncell (After light attenuation) | Power drop/% |
|---|---|---|---|
| Embodiment 1 | 23.30% | 23.22% | 0.34% |
| Comparative Example 2 | 23.30% | 23.10% | 0.86% |

In the above table, NCell is the conversion efficiency.

As can be seen from the above table, the power drop of Embodiment 1 is less than that of Comparative Example 2, indicating that the silicon dioxide layer has a certain improvement effect on LeTID.

From the above description, it can be seen that the above embodiments of the present disclosure achieve the following technical effects: by adding a first heavily doped region and a second heavily doped region with a relatively high doping concentration on the basis of the first doped region and the second doped region, the ohmic contact of the device can be enhanced, the series resistance can be reduced, and the carrier recombination probability can be reduced. Meanwhile, the first passivation layer with fixed negative charges and the second passivation layer with fixed positive charges in the solar cell structure achieve the partition passivation of the first doped region and the second doped region, improve the collection efficiency of photo-generated carriers, and further improve the conversion efficiency of the solar cell structure.

The foregoing is merely a preferred embodiment of the present disclosure and is not intended to limit the present disclosure which may be subject to various modifications and variations to those skilled in the art. Any modifications, equivalents, substitutions, improvements, etc. made within the spirit and principles of this disclosure shall be included within the scope of protection of the present disclosure.

## Claims

1. A solar cell structure, comprising:
a semiconductor substrate having a first doped region and a second doped region formed on a back side of the semiconductor substrate;
a first heavily doped region formed in the semiconductor substrate, the first heavily doped region being disposed in contact with a side of the first doped region away from the back side, either of the first heavily doped region and the first doped region being a P-type doped region, and a doping concentration of the first heavily doped region being greater than a doping concentration of the first doped region;
a second heavily doped region formed in the semiconductor substrate, the second heavily doped region being disposed in contact with a side of the second doped region away from the back side, either of the second heavily doped region and the second doped region being an N-type doped region, and a doping concentration of the second heavily doped region being greater than a doping concentration of the second doped region;
a first passivation layer formed on the side of the first doped region away from the first heavily doped region, the first passivation layer having fixed negative charges; and
a second passivation layer at least formed on the side of the second doped region away from the second heavily doped region, the second passivation layer having fixed positive charges.

2. The solar cell structure according to claim 1, wherein the back side of the semiconductor substrate is provided with a recess, the first doped region is formed in a region corresponding to the recess in the back side, the second doped region is formed in a region on either side of the recess in the back side, and the first passivation layer is formed in the recess, the recess preferably having a depth of 10 to 100 µm.

3. The solar cell structure according to claim 2, wherein a part of the second passivation layer is formed on the side of the second doped region away from the second heavily doped region, and another part of the second passivation layer is formed on a side of the first passivation layer away from the first doped region.

4. The solar cell structure according to claim 1, wherein
the doping concentrations of the first doped region and the second doped region are independently selected from 10¹⁸ to 10²⁰ cm⁻³; and
the doping concentrations of the first heavily doped region and the second heavily doped region are independently selected from 10²⁰ to 10²² cm⁻³.

5. The solar cell structure according to claim 1, wherein the first doped region and the second doped region are polysilicon doped structures, and the solar cell structure further comprises:
a tunneling oxide layer covering either of side surfaces of the polysilicon doped structures away from the first passivation layer and the second passivation layer and preferably having a thickness of 1 to 2 nm.

6. The solar cell structure according to claim 1, wherein the first passivation layer comprises any one or more of an alumina layer, a gallium oxide layer, a stack of alumina and silicon nitride, and a stack of gallium oxide and silicon nitride.

7. The solar cell structure according to claim 1, wherein the second passivation layer comprises any one or more of a silicon nitride layer and a hydrogenated amorphous silicon layer.

8. The solar cell structure according to any one of claims 1 to 7, wherein the semiconductor substrate is a silicon substrate, and the solar cell structure further comprises:
a silicon dioxide layer covering the back side, a part of the silicon dioxide layer being located between the first doped region and the first passivation layer, another part of the silicon dioxide layer being located between the second doped region and the second passivation layer, and the silicon dioxide layer preferably having a thickness of 2 to 10 nm.

9. The solar cell structure according to any one of claims 1 to 7, wherein the solar cell structure further comprises:
a front surface field formed on a front side of the semiconductor substrate, the semiconductor substrate being a doped substrate, the front surface field is of the same doping type as the doped substrate, and a doping concentration of the front surface field being greater than a doping concentration of the doped substrate; or
a front floating junction formed on a front side of the semiconductor substrate, the semiconductor substrate being a doped substrate, the front floating junction is of an opposite doping type to the doped substrate, and a doping concentration of the front floating junction being greater than a doping concentration of the doped substrate.

10. A manufacturing method of the solar cell structure according to any one of claims 1 to 9, comprising:
forming a first doped region and a second doped region on a back side of a semiconductor substrate;
forming a first heavily doped region being in contact with a side of the first doped region away from the back side and a second heavily doped region being in contact with a side of the second doped region away from the back side in the semiconductor substrate, wherein either of the first heavily doped region and the first doped region is a P-type doped region, either of the second heavily doped region and the second doped region is an N-type doped region, and a doping concentration of the first heavily doped region is greater than a doping concentration of the first doped region, and a doping concentration of the second heavily doped region is greater than a doping concentration of the second doped region;
forming a first passivation layer on a side of the first doped region away from the first heavily doped region, the first passivation layer having fixed negative charges; and
forming a second passivation layer at least on a side of the second doped region away from the second heavily doped region, the second passivation layer having fixed positive charges.

11. The manufacturing method according to claim 10, wherein forming the first doped region and the second doped region comprises:
depositing an intrinsic polysilicon material on the back side of the semiconductor substrate, and subjecting the polysilicon material to N-type ion diffusion and P-type ion diffusion, to form the first doped region and the second doped region; or
performing in situ doping on the back side of the semiconductor substrate using N-type ions and P-type ions, respectively, to form the first doping region and the second doping region, wherein the semiconductor substrate is a polycrystalline silicon substrate.

12. The manufacturing method according to claim 11, wherein prior to forming the first doped region and the second doped region, the manufacturing method further comprises:
forming a tunneling oxide layer on the back side of the semiconductor substrate,
after forming the first passivation layer and the second passivation layer, the first passivation layer and a part of the tunneling oxide layer are located on either side of the first doped region, and the second passivation layer and another part of the tunneling oxide layer are located on either side of the second doping region.

13. The manufacturing method according to any one of claims 10 to 12, wherein prior to forming the first doped region and the second doped region, the manufacturing method further comprises:
etching the back side of the semiconductor substrate to form a recess; and
forming the first doped region in a region in the back side corresponding to the recess, and
forming the second doped region in a region in the back side on either side of the recess, in forming the first doped region and the second doped region.

14. The manufacturing method according to claim 13, wherein forming the first passivation layer and the second passivation layer comprises:
covering the back side of the semiconductor substrate with a silicon dioxide layer such that a part of the silicon dioxide layer covers a bottom surface and an inner wall of the recess and is in contact with the first doped region, and another part of the silicon dioxide layer is in contact with the second doped region;
forming the first passivation layer in the recess; and
covering surfaces of the first passivation layer and the silicon dioxide layer with the second passivation layer.

15. The manufacturing method according to any one of claims 10 to 12, wherein forming the first heavily doped region and the second heavily doped region comprises:
performing selective emitter laser doping on the back side of the semiconductor substrate with P-type ions to form the first heavily doped region, preferably using a picosecond laser of 355 nm with a pulse width of 10-20 ps and a working frequency of 10-80 MHz; and
performing selective emitter laser doping on the back side of the semiconductor substrate with N-type ions to form the second heavily doped region, preferably using a nanosecond laser of 532 nm with a pulse width of 6-20 ns and a working frequency 50-200 KHz.
